# EUROPEAN PATENT APPLICATION

(11) **EP 1 562 289 A2**
(43) Date of publication of application: **10.08.2005**
(21) Application number: 05002294.6
(22) Date of filing: 03.02.2005
(51) Int. Cl.: H03H 9/10, H03H 3/08

(54) **Electronic part and method of manufacturing the same**

(30) Priority: 04.02.2004 JP 2004027588
(71) Applicant: ALPS ELECTRIC CO., LTD., Tokyo 145-8501 (JP)
(72) Inventor: Takeuchi, Hideaki, Ota-ku Tokyo 145-8501 (JP); Sasaki, Hitoshi, Ota-ku Tokyo 145-8501 (JP); Kondo, Hideki, Ota-ku Tokyo 145-8501 (JP); Waga, Satoshi, Ota-ku Tokyo 145-8501 (JP)
(74) Representative: Klunker . Schmitt-Nilson . Hirsch

(57) **Abstract**

An electronic part which can be miniaturized is provided. A bottom surface of a substrate of an electronic element is positioned on the same virtual plane of an upper surface of a sidewall portion of a case body, and a seal material is covered thereon. Accordingly, a gap between the seal material and the bottom surface of the electronic element is not formed, and thus the electronic part can easily be made thin. Also, since the seal material is formed by a resin, even when positions of the bottom surface of the substrate and an upper surface of the sidewall portion are deviated, the deviation can be easily absorbed.

## Description

### BACKGROUND OF THE INVENTION

### 1. Field of the Invention

The present invention relates to an electronic part in which an electronic element is sealed in a case body and a method of manufacturing the same, and more particularly to an electronic part having a miniaturized case body and a method of manufacturing the same.

### 2. Description of the Related Art

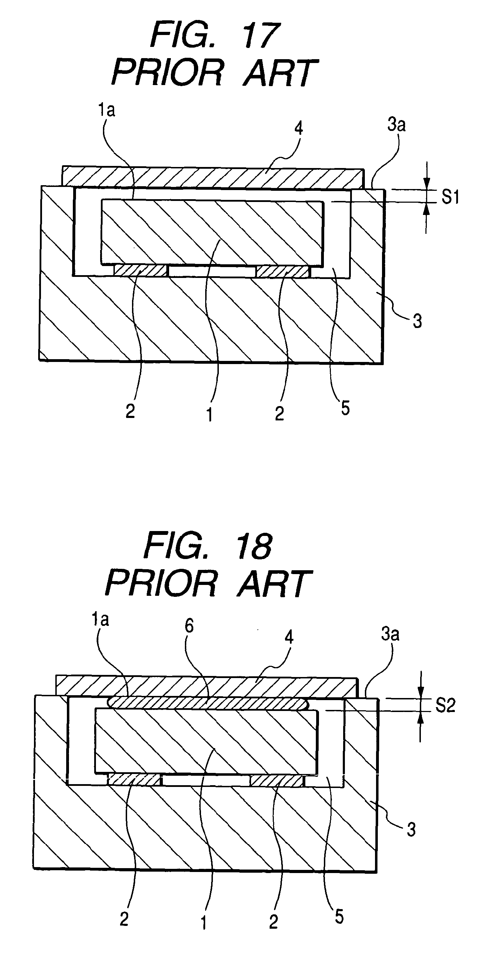

Figs. 17 and 18 are cross sectional views showing the structure that a surface acoustic element is sealed in a concave portion provided in a case body made of ceramic. The structure of Fig. 17 is described in Japanese unexamined Patent Application Publication No. 2001-77659 and the structure of Fig. 18 is described in Japanese unexamined Patent Application Publication No. 2003-87093.

A case body 3 of an electric part shown in Fig. 17 is formed with the concave portion, and an accommodating portion 5 in which an electronic element 1 is accommodated by the concave portion is formed. The electronic element 1 is accommodated in the accommodating portion 5 and the electronic element 1 is mounted in the accommodating portion 5 on the case body 3. The electronic element 1 is formed with a terminal (not shown) and the terminal is electrically connected to a connecting land 2 formed in the accommodating portion 5.

The electronic element 1 is, for example, a band pass filter formed by using the surface acoustic element. The surface acoustic element has a structure that teeth portions of a pair of teeth-shaped electrodes (IDT (inter-digital transducer) electrodes) which is made of a conductive material having a low specific gravity are differently arranged on the surface of a piezoelectric substrate. The surface acoustic element having such a simple structure is a suitable element to miniature a filter, a resonator or a duplexer mounted in mobile communication terminals.

The upper side of the accommodating portion 5 is an open surface, and a cover body 4 made of a metal is formed so as to close the open surface. By sealing the accommodating portion 5 with the cover body 4, the electronic element 1 accommodated in the accommodating portion 5 is sealed in the accommodating portion 5.

The electronic part shown in Fig. 18 is provided with a conductive resin 6 between the electronic element 1 and the cover body 4, and thereby the Joule heat generated from the electronic element 1 is easily emitted to the outside.

In the electronic part shown in Fig. 17, in order to seal the electronic element 1 in the accommodating portion 5, an upper surface 3a of the case body 3 must be positioned at a height higher than a bottom surface 1a of the electronic element 1, thereby generating a gap s1 between the cover body 4 and the bottom surface 1a of the electronic element 1. On this account, it is difficult to make an electronic part thin. Also, in the electronic part shown in Fig. 18, similarly, a gap s2 is formed between the cover body 4 and the electronic element 1.

### SUMMARY OF THE INVENTION

The present invention is designed to solve the above-mentioned problems, and it is an object of the present invention is to provide an electronic part and a method of manufacturing the same, in which the electronic part can be made thin by reducing or eliminating a gap between a cover body and an electronic element.

The electronic part according to the present invention comprises a substrate on which an electronic element is mounted or is formed and a case body having an accommodating part for accommodating the substrate, wherein the substrate is accommodated in the accommodating portion so that the surface thereof is opposed to a bottom surface of the accommodating portion, and resin seal material is provided over a range from the bottom surface of the substrate to the sidewall portion around the accommodating portion of the case body, and a metal film is laminated on the seal material.

In the present invention, since the resin seal material is provided over a range from the bottom surface of the substrate to the sidewall portion around the accommodating portion of the case body and the metal film is laminated on the seal material, the height difference between an upper surface of the sidewall portion of the case body and a bottom surface of the electronic element can be reduced, thereby the electronic part can be made thin.

Particularly, when a bottom surface of the substrate is positioned on the same virtual plane of an upper surface of the sidewall portion of the case body, or the bottom surface of the substrate is positioned at a height higher than an upper surface of the sidewall portion of the case body, a gap between the cover body and the electronic element is removed, thereby the electronic part can be further made thin.

The seal material may have a uniform thickness throughout an overall area of a bottom surface of the substrate. Also, when a surface of the seal material on a bottom surface of the substrate is formed with irregularities, the surface area of the seal material is increased and thus the emitting effect of the Joule heat generated from the electronic part is increased.

In addition, it is preferable that the seal material is formed over a range from a peripheral portion of the bottom surface of the substrate to a sidewall portion of the case body, and a through-hole is formed in the seal material on an inside of a bottom surface of the substrate, thereby the area that the metal film is directly laminated on the substrate is provided. Thereby, the emitting effect of the Joule heat generated from the electronic element is further increased. Particularly, it is more preferable that the surface of the metal film is formed with irregularities on a bottom surface of the substrate.

Also, it is preferable that the metal film is electrically connected to a connecting portion provided on a lower surface of the case body through a conductive portion provided at an outside or inside of the bottom portion of the case body and at an outside or inside of the sidewall portion of the case body, thereby increasing the shield effect.

Furthermore, it is preferable that the conductive portion is formed inside a groove portion provided at an outside of the sidewall portion of the case body, and a lower end of the groove portion is positioned inside the sidewall portion of the case body so that the bottom of the case body is not exposed. If a lower end of the groove portion is not exposed to a bottom surface of the case body, the solder can be prevented from being sucked into the groove portion when soldering the electronic part on the wiring substrate.

The method of manufacturing an electronic part according to the present invention comprises the steps of: (a) forming a concave portion in a case body to provide an accommodating portion; (b) accommodating a substrate on which an electronic element is mounted or formed in the accommodating portion so that the surface of the substrate is opposed to a bottom surface of the accommodating portion, thereby the bottom surface of the substrate is directed upward; (c) providing a resin seal material over a range from the bottom surface of the substrate to a sidewall portion around the accommodating portion of the case body; and (d) laminating a metal film on the seal material.

In the present invention, it is preferable that, in step (b), the substrate is arranged so that the bottom surface of the substrate is positioned at the same virtual plane of an upper surface of the sidewall portion of the case body, or the substrate is arranged so that the bottom surface of the substrate is positioned at a height higher than an upper surface of the sidewall portion of the case body.

In the present invention, it is preferable that, in step (c), the seal material has a uniform thickness throughout an overall area of a bottom surface of the substrate. Also, it is more preferable that the surface of the seal material on a bottom surface of the substrate may be formed with irregularities.

In addition, it is preferable that, in step (c), a through-hole is formed in the seal material on an inside of the bottom surface of the substrate, and, in step (d), the metal film is directly laminated on the substrate exposed to the through-hole.

Furthermore, it is preferable that, in step (d), the metal film is formed so that the surface thereof has the irregularities on the bottom surface of the substrate. As a method for electrically connecting the metal film to the connecting portion provided on a bottom surface of the case body through the conductive portion provided at an outside or inside of the bottom portion of the case body or at an outside or inside of the sidewall portion of the case body to increase the shield effect, there is a method which further comprises, before step (a), a step (e) of forming a connecting portion electrically connected to the electronic element and a connecting portion electrically connected to the metal film, on a bottom surface of the case body, before step (a) or the step (b), a step (f) of forming a conductive portion electrically connected to the connecting portion of a bottom surface of the case body at an outside or inside of the sidewall portion of the case body, wherein, in step (c), the seal material on the conductive portion is removed after covering the conductive portion by the seal material, and in step (d), the metal film and the conductive portion are connected to each other.

In the present invention, since a resin seal material is provided over a range from the bottom surface of the substrate to the sidewall portion around the accommodating portion of the case body and the metal film is laminated on the seal material, the height difference between an upper surface of the sidewall portion of the case body and the bottom surface of the electronic part can be reduced, thereby thinning the electronic part.

Particularly, since a bottom surface of the substrate is positioned on the same virtual plane of an upper surface of the sidewall portion of the case body, or the bottom surface of the substrate is positioned at a height higher than the upper surface of the sidewall portion of the case body, the gap between the cover body and the electronic element can be removed, thereby further thinning the electronic part.

In addition, since a seal material is formed over a range from the peripheral portion of the bottom surface of the substrate to the sidewall portion of the case body, and a through-hole is formed in the seal material on an inside of the bottom surface of the substrate, thereby the area that the metal film is directly laminated on the substrate is provided, and accordingly the emitting effect of the Joule heat generated from the electronic element is further increased.

Also, since a metal film is electrically connected to a connecting portion provided on a lower surface of the case body through a conductive portion provided at an outside or inside of the bottom portion of the case body and at an outside or inside of the sidewall portion of the case body, the shield effect is increased.

### BRIEF DESCRIPTION OF THE DRAWINGS

Fig. 1 is a cross sectional view of an electronic part according to a first embodiment of the present invention;
Fig. 2 is a plan view of the electronic part according to the first embodiment of the present invention;
Fig. 3 is a cross sectional view of an electronic part according to a second embodiment of the present invention;
Fig. 4 is a cross sectional view of an electronic part according to a third embodiment of the present invention;
Fig. 5 is a cross sectional view of an electronic part according to a fourth embodiment of the present invention;
Fig. 6 is a cross sectional view of an electronic part according to a fifth embodiment of the present invention;
Fig. 7 is a cross sectional view of an electronic part according to a sixth embodiment of the present invention;
Fig. 8 is a cross sectional view showing a step in a method of manufacturing the electronic part shown in Fig. 1;
Fig. 9 is a cross sectional view showing a step in a method of manufacturing the electronic part shown in Fig. 1;
Fig. 10 is a cross sectional view showing a step in a method of manufacturing the electronic part shown in Fig. 1;
Fig. 11 is a cross sectional view showing a step in a method of manufacturing the electronic part shown in Fig. 1;
Fig. 12 is a cross sectional view showing a step in a method of manufacturing the electronic part shown in Fig. 1;
Fig. 13 is a cross sectional view showing a step in a method of manufacturing the electronic part shown in Fig. 4;
Fig. 14 is a cross sectional view showing a step in a method of manufacturing the electronic part shown in Fig. 4;
Fig. 15 is a cross sectional view showing a step in a method of manufacturing the electronic part shown in Fig. 4;
Fig. 16 is a plan view of an electronic part according to a seventh embodiment of the present invention;
Fig. 17 is a cross sectional view of a conventional electronic part; and
Fig. 18 is a cross sectional view of a conventional electronic part.

### DESCRIPTION OF THE PREFERRED EMBODIMENT

Hereinafter, embodiments of the present invention will now be described with reference to the drawings.

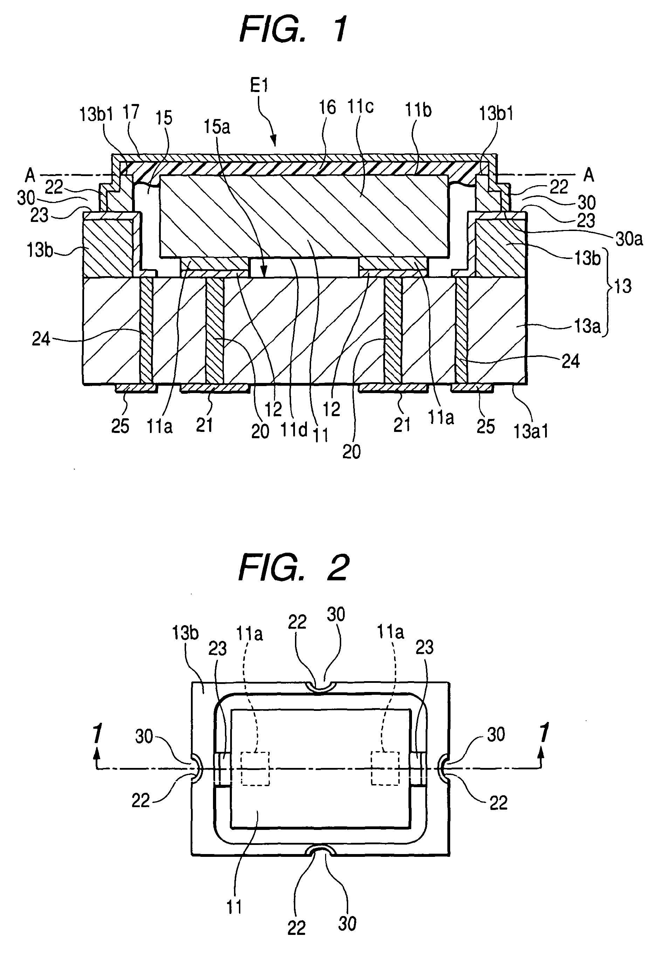

Fig. 1 is a cross sectional view of an electronic part according to a first embodiment of the present invention. The electronic part shown in Fig. 1 is formed by sealing a surface acoustic element in a concave portion provided in a case body made of ceramic.

In the case body 13 composed of a laminated substrate made of ceramic in the electronic part E1 shown in Fig. 1, a concave portion is formed by providing a sidewall portion 13b on the bottom portion 13a. By this concave portion, an accommodating portion 15 for accommodating an electronic element 11 is formed. The substrate 11c of the electronic element 11 is accommodated in the accommodating portion 15 so that the surface 11d thereof is opposed to a bottom surface 15a of the accommodating portion 15, and thus the bottom surface 11b of the substrate 11c is directed upward.

The electronic element 11 is formed with terminals 11a, 11a, and the terminals 11a, 11a are electrically connected to connecting lands 12, 12 formed in the accommodating portion 15. The lands 12, 12 are electrically connected to the connecting portions 21, 21 provided on a lower surface of the bottom portion 13a through conducting portions 20, 20 passing through the bottom portion 13a of the case body 13.

The electronic element 11 is, for example, a band pass filter formed by using a surface acoustic element. The surface acoustic element has the structure that the teeth portions of a pair of teeth-shaped electrodes (IDT (inter-digital transducer) electrodes) which is made of conductive material having a low specific gravity are differently arranged on the surface of a piezoelectric substrate. The surface acoustic element having such a simple structure is the suitable element to miniature a filter, a resonator or a duplexer mounted in a mobile communication terminal.

The upper side of the accommodating portion 15 is an open surface and, in order to close the open surface, seal material 16 made of resin is provided over a range from the bottom surface 11b of the substrate 11c of the electronic element 11 to the sidewall portion 13b around the accommodating portion 15 of the case body 13. In addition, a metal film 17 is laminated on the seal material'16. The seal material 16 is formed by thermosetting resin such as epoxy resin or polyimide resin. Particularly, it is preferable that epoxy resin having low water permeability is used. By sealing the accommodating portion 15 with the sealing material 16, the electronic element 11 accommodated in the accommodating portion 15 is sealed in the accommodating portion 15.

In the electronic part shown in Fig. 1, the bottom surface 11b of the substrate 11c of the electronic element 11 is positioned on the same virtual plane A of an upper surface 13b1 of the sidewall portion 13b of the case body 13. Accordingly, the gap is not formed between the seal material 16 and the bottom surface 11b of the electronic element 11, thereby it becomes.easier to make the electronic part thin. Also, since the seal material 16 is made of resin, even when the positions of the bottom surface 11b of the substrate 11c and an upper surface 13b1 of the sidewall portion 13b are deviated, the deviation can be easily absorbed.

Furthermore, within the range that the accommodating portion 15 is sealed with the seal material 16, the bottom surface 11b of the substrate 11c of the electronic element 11 may be positioned at a height higher than an upper surface 13b1 of the sidewall portion 13b of the case body 13.

In Fig. 1, the seal material 16 has a uniform thickness throughout an overall area of the bottom surface 11b of the substrate 11c. There is a case that the seal material 16 is slightly drooped downward between the bottom surface 11b of the substrate 11c and the sidewall portion.

As shown in Fig. 1, a conductive portion 22 and a conductive portion 23 composed of conductive material are provided at an outside and inside of the sidewall portion 13 of the case body 13 of the electronic part E1. In addition, a connecting portion 25 is provided at a bottom surface of the case body 13 and the conductive portion 24 passing through the bottom portion 13a of the case body 13. The conductive portions 22, 23, 24 and the connecting portion 25 are electrically connected, and the connecting portion 25 is grounded. By connecting the conductive portion 22 and the metal film 17, the metal film 17 is grounded, and thus the shield effect of the metal film 17 can be improved.

In addition, the conductive portion 22 connected to the metal film 17 is formed inside a groove portion 30 provided at an outside of the sidewall portion 13b of the case body 13. A lower end 30a of the groove portion 30 is positioned inside the sidewall portion 13b of the case body 13 so as not to be exposed to a bottom surface 13a1 of the case body 13. Thereby, the solder can be prevented from being sucked into the groove portion 30 when soldering the electronic part E1 on the wiring substrate.

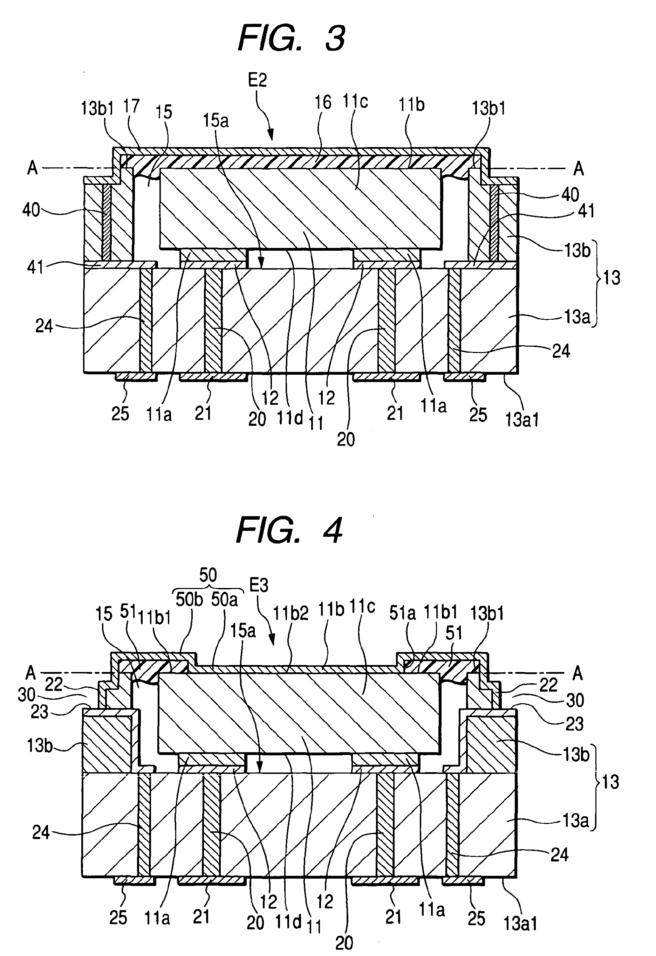

The plan view of the state that the metal film 17 of the electronic part of Fig. 1 is detached is shown in Fig. 2. Also, Fig. 1 is a cross sectional view when the electronic part cut along the line 1-1 in Fig. 2 is seen from the arrow direction. Fig. 3 is a cross sectional view of the electronic part E2 according to a second embodiment of the present invention. The electronic part E2 shown in Fig. 3 is different from the electronic part E1 shown in Fig. 1 only in that a conductive portion 40 and a conductive portion 41 composed of conductive material are provided inside the sidewall portion 13b of the case body 13. The conductive portions 40, 41, 42 and the connecting portion 25 are electrically connected and the connecting portion 25 is grounded. By connecting the conductive portion 40 and the metal film 17, the metal film 17 is grounded and thus the shield effect of the metal film 17 can be improved.

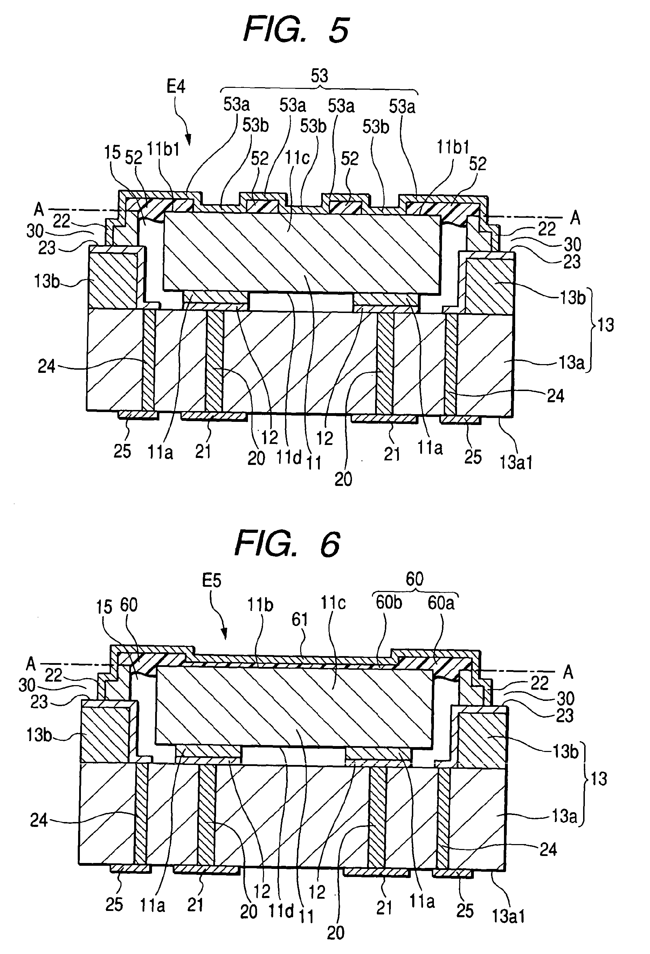

Figs. 4 and 5 are cross sectional views of electronic parts according to third and fourth embodiments of the present invention, respectively.

In the electronic part E3 shown in Fig. 4, a seal material 51 is formed over a range from a peripheral portion 11b1 of the bottom surface 11b of the substrate 11c of the electronic element 11 to the case body 13b, a through-hole 51a is formed in the seal material 51 on an inside portion 11b2 of the bottom surface 11b of the substrate 11c, thereby the area that the metal film 50 is directly laminated on the substrate 11c is provided. If the metal film 50 is directly laminated on the substrate 11c, the emitting effect of the Joule heat generated from the electronic element 11 becomes increased. The surface of the metal film 50 is formed with irregularities composed of a concave portion 50a and a convex portion 50b on the bottom surface 11b of the substrate 11c, thereby increasing the surface area and thus further increasing the emitting effect of the Joule heat.

The electronic part E4 shown in Fig. 5 is similar to the electronic part E3 shown in Fig. 4 and is different from it in that, on an inside portion 11b2 of the bottom surface 11b of the substrate 11c, a plurality of through-holes are formed in the seal material 52 and a metal film 53 is directly laminated on the substrate 11c in the through-hole. The surface of the metal film 53 is formed with irregularities composed of a concave portion 53b and a convex portion 53a on the bottom surface 11b of the substrate 11c.

The electronic part E4 shown in Fig. 5 has the same effect as the electronic part E3 shown in Fig. 4.

The electronic parts E3, E4 shown in Figs. 4 and 5 does not need the expensive conductive resin 6 between the electronic element 1 and the cover body 4, unlike the conventional electronic part shown in Fig. 18, and thus the structure for efficiently emitting the Joule heat generated from the electronic element 11 to an outside thereof can be realized with a low cost.

The electronic part E5 shown in Fig. 6 is similar to the electronic part E3 shown in Fig. 4 and is different from it in that the surface of seal material 60 on the bottom surface 11b of the substrate 11c of the electronic part 11 is formed with irregularities having a concave portion 60b and a convex portion 60a, without forming the through-hole in the seal material 60. Also, the surface of the metal film 61 laminated on the seal material 60 is formed with irregularities.

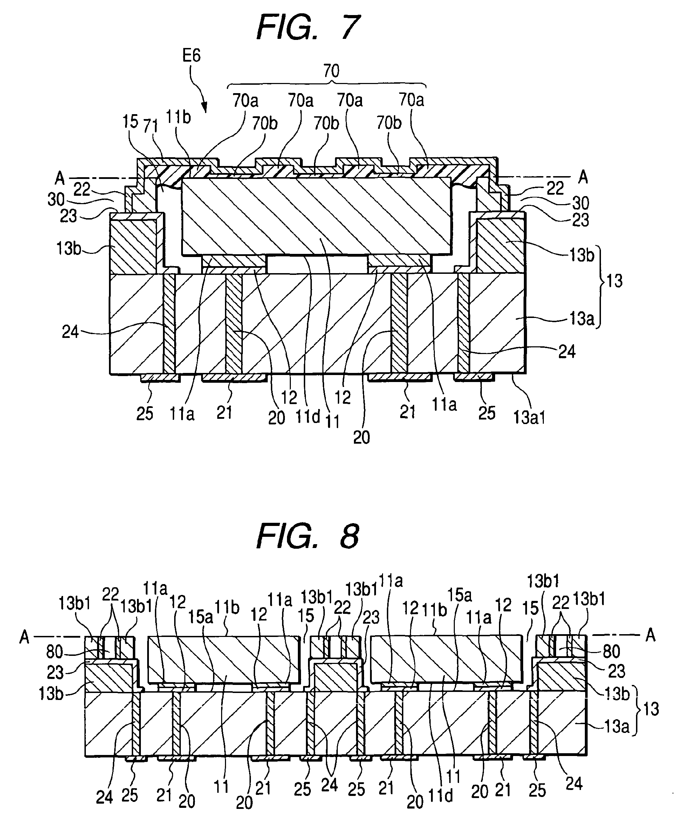

The electronic part E6 shown in Fig. 7 is similar to the electronic part E4 shown in Fig. 5 and is different from it in that the surface of seal material 70 on the bottom surface 11b of the substrate 11c of the electronic part 11 is formed with irregularities having a concave portion 70b and a convex portion 70a, without forming the through-hole in the seal material 70. Also, the surface of the metal film 71 laminated on the seal material 70 is formed with irregularities.

The electronic parts shown in Figs. 6 and 7 can realize the structure for efficiently emitting the Joule heat generated from the electronic element 11 to an outside thereof with a low cost.

Now, a method of manufacturing the electronic part shown in Fig. 1 will be described.

Figs. 8 to 12 are cross sectional views showing a method of manufacturing the electronic part shown in Fig. 1. First, the connecting portion 21 and the connecting portion 25 are provided on the lower surfaces of the case body 13 and the conductive portion 24 and the conductive portion 20 passing through the bottom portion 13a of the case body 13, and the land 12 is formed on the conductive portion 24. Next, the sidewall portion 13b is formed by laminating the substrate on the bottom portion 13a of the case body 13. The conductive portion 22 and the conductive portion 23 composed of the conductive material are formed inside the sidewall portion 13b. The conductive portion 22 is formed by laminating the substrate having a hole 80 therein on the conductive portion 23 and then plating the inner peripheral surface of the hole 80.

By providing the sidewall portion 13b on the bottom portion 13a of the case body 13, a concave portion is formed. By the concave portion, the accommodating portion 15 for accommodating the electronic element 11 is formed.

Next, the electronic element 11 is accommodated in the accommodating portion 15 so that the surface 11d of the substrate 11c of the electronic element 11 is opposed to a bottom surface 15a of the accommodating portion 15. Accordingly, the bottom surface 11b of the substrate 11c is directed upward. The electronic element 11 is formed with the terminals 11a, 11a and the terminal 11a, 11a are electrically connected to the connecting lands 12, 12 formed in the accommodating portion 15.

The lands 12, 12 are electrically connected to the connecting portions 21, 21 provided in the lower surface of the bottom portion 13a through the conductive portions 20, 20 passing through the bottom portion 13a of the case body 13.

The electronic element 11 is, for example, the band pass filter formed by using the surface acoustic element. Also, the bottom surface 11b of the substrate 11c of the electronic element 11 is positioned on the same virtual plane A of an upper surface 13b1 of the sidewall portion 13b of the case body 13. Alternatively, the substrate 11c may be arranged so that the bottom surface 11b of the substrate 11c is positioned at a height higher than an upper surface 13b1 of the sidewall portion 13b of the case body 13.

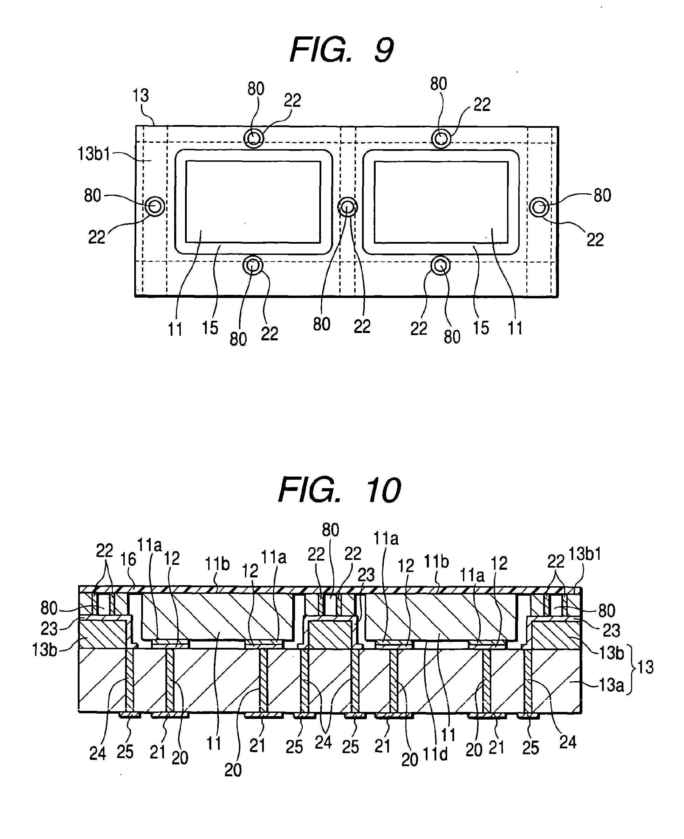

The plan view of the electronic part at the step shown in Fig. 8 is shown in Fig. 9. In addition, although the case that two electronic parts are simultaneously formed is shown in Figs. 8 to 12, the number of the electronic parts which are simultaneously formed can be optionally determined.

Next, as shown in Fig. 10, in order to close the open surface at the upper side of the accommodating. portion 15, the resin seal material 16 is provided over a range from the bottom surface 11b of the substrate 11c of the electronic element 11 to the sidewall portion 13b around the accommodating portion 15 of the case body 13 and is cured by applying heat. The seal material 16 is formed by, for example, epoxy resin or polyimide resin. Particularly, it is preferable that epoxy resin having low water permeability is used. By sealing the accommodating portion 15 with the seal material 16, the electronic element 11 accommodated in the accommodating portion 15 is sealed in the accommodating portion 15. In Fig. 10, the seal material 16 has the uniform thickness throughout an overall area of the bottom surface 11b of the substrate 11c. Like the present embodiment, even when a plurality of the electronic parts are simultaneously formed, the overall electronic parts may be sealed with one seal material 16.

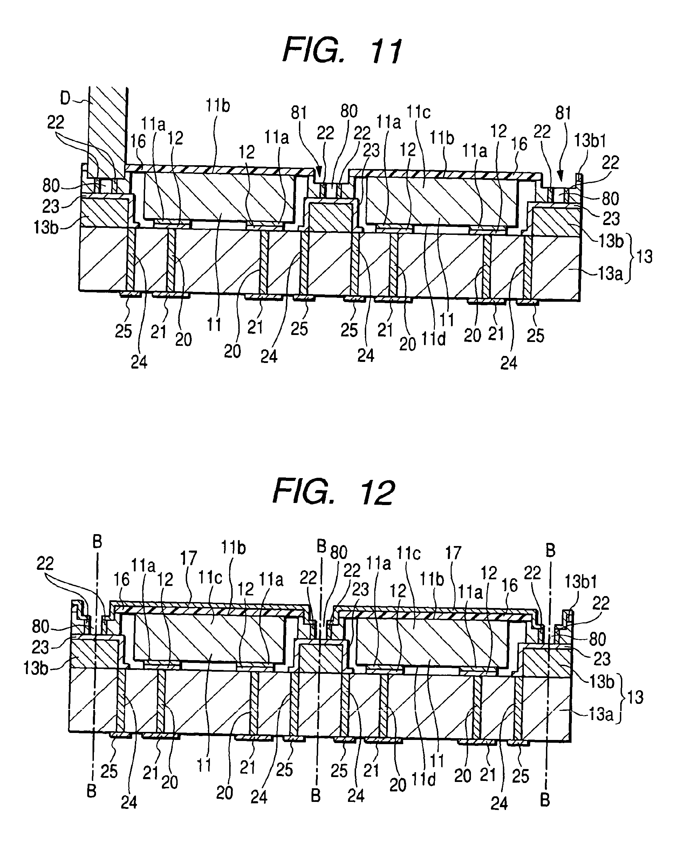

Next, in the step shown in Fig. 11, the seal material on the conductive portion 22 is removed by using a dicing blade D to expose an upper surface of the conductive portion 22 to an inside of the groove portion 81. The dicing is performed with a lattice shape along a dotted line of the Fig. 9. Since the dicing step of Fig. 11 is to expose the conductive portion 22 extended in the thickness direction of the sidewall portion 13b of the case body 13, it does not require high precision. If the conductive portion 23 is overlapped on the lower surface of the seal material 16 without forming the conductive portion 22 extended in the thickness direction of the sidewall portion 13b, the surface of the conductive portion 23 is exposed, thereby an expensive laser apparatus having high manufacturing precision is required.

Next, in the step shown in Fig. 12, the metal film 17 is formed on the seal material 16 and the conducting portion 22 by a plating. The conductive portions 22, 23, 24 and the connecting portion 25 are electrically connected and the connecting portion 25 is grounded. By connecting the conductive portion 22 and the metal film 17, the metal film 17 is grounded and thus the shield effect of the metal film 17 can be improved.

In addition, it is diced along a dashed dot line B-B and is separated into two electronic parts.

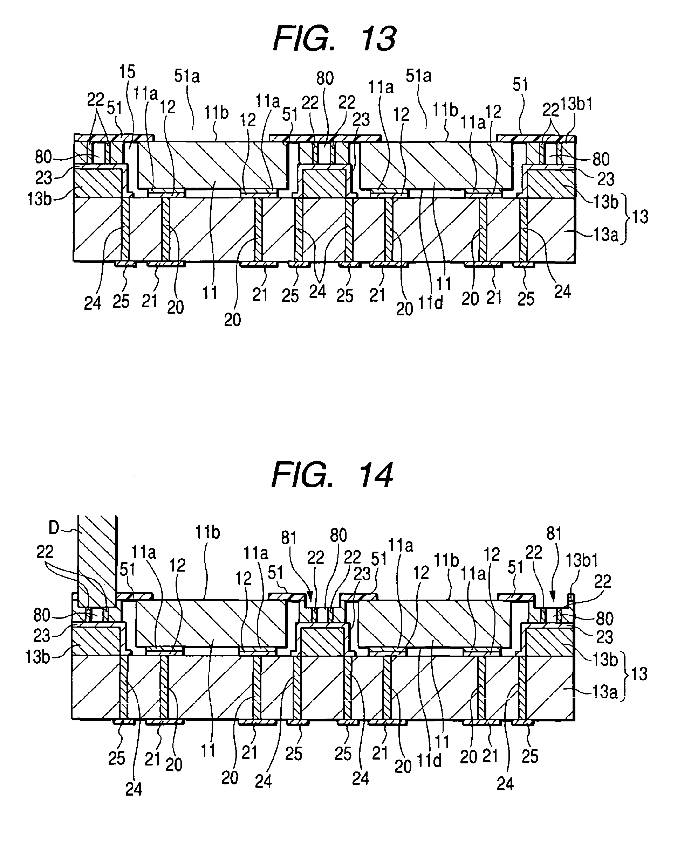

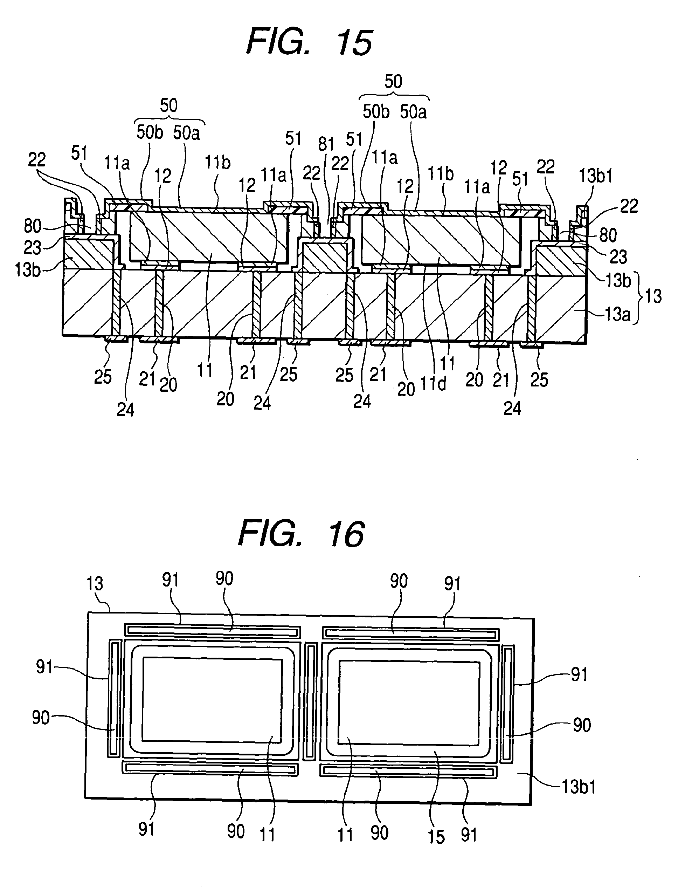

When forming the electronic part shown in Fig. 4, after the step shown in Fig. 10, the through-hole 51a is formed in the seal material 51 on an inside of the bottom surface 11b of the substrate 11c, as shown in Fig. 13, and an upper surface of the conductive portion 22 is exposed in the step shown in Fig. 14, and the metal film 50 is formed by a plating in the step shown in Fig. 15. At this time, the concave portion 50a of the metal film 50 is directly laminated on the substrate 11c exposed in the through-hole 51a. Alternatively, the seal material 51 having the through-hole 51a therein may be arranged so that the through-hole 51a is positioned on an inside of the bottom surface 11b of the substrate 11c.

Also, instead of forming the through-hole in the seal material, by forming irregularities in the surface of the seal material, the electronic part shown in Fig. 6 or 7 can be formed.

Also, in the above-mentioned embodiment, the conductive portion 22 is formed by laminating the substrate having the hole 80 therein on the conductive portion 23 and by performing the plating on the inner peripheral surface of the hole 80. The shape of the hole is not limited to the circular shape, and the conductive portion 91 corresponding to the conductive portion 22 may be formed on the inner peripheral surface of the rectangular hole 90 by a plating, as shown in Fig. 16.

## Claims

1. An electronic part comprising:
a substrate on which an electronic element is mounted or is formed; and
a case body having an accommodating part for accommodating the substrate,
wherein the substrate is accommodated in the accommodating portion so that a surface of the substrate opposes a bottom surface of the accommodating portion and a bottom surface of the substrate is directed upward, a resin seal material is provided over a range from the bottom surface of the substrate to a sidewall portion around the accommodating portion of the case body, and a metal film is laminated on the seal material.

2. The electronic part according to claim 1,
wherein the bottom surface of the substrate is positioned on the same virtual plane of an upper surface of the sidewall portion of the case body.

3. The electronic part according to claim 1,
wherein the bottom surface of the substrate is positioned at a height higher than an upper surface of the sidewall portion of the case body.

4. The electronic part according to any of claims 1 to 3,
wherein the seal material has a uniform thickness throughout an overall area of the bottom surface of the substrate.

5. The electronic part according to any of claims 1 to 4,
wherein a surface of the seal material on the bottom surface of the substrate is formed with irregularities.

6. The electronic part according to any of claims 1 to 5,
wherein the seal material is formed over a range from a peripheral portion of the bottom surface of the substrate to the sidewall portion of the case body, a through-hole is formed in the seal material on an inside of the bottom surface of the substrate, thereby an area that the metal film is directly laminated on the substrate is provided.

7. The electric part according to claim 5 or 6,
wherein the surface of the metal film is formed with irregularities on the bottom surface of the substrate.

8. The electric part according to any of claims 1 to 7,
wherein the metal film is electrically connected to a connecting portion provided on a lower surface of the case body through a conductive portion provided at an outside or inside of a bottom portion of the case body and at an outside or inside of the sidewall portion of the case body.

9. The electronic part according to any of claims 1 to 8,
wherein a conductive portion is formed inside a groove portion provided at an outside of the sidewall portion of the case body, and a lower end of the groove portion is positioned inside the sidewall portion of the case body so that a bottom of the case body is not exposed.

10. A method of manufacturing an electronic part, comprising the steps of:
(a) forming a concave portion in a case body to provide an accommodating portion;
(b) accommodating a substrate on which an electronic element is mounted or formed in the accommodating portion so that a surface of the substrate opposes to a bottom surface of the accommodating portion and a bottom surface of the substrate is directed upward;
(c) providing a resin seal material over a range from the bottom surface of the substrate to a sidewall portion around the accommodating portion of the case body; and
(d) laminating a metal film on the seal material.

11. The method according to claim 10,
wherein, in step (b), the substrate is arranged so that the bottom surface of the substrate is positioned at the same virtual plane of an upper surface of the sidewall portion of the case body.

12. The method according to claim 10,
wherein, in step (b), the substrate is arranged so that the bottom surface of the substrate is positioned at a height higher than an upper surface of the sidewall portion of the case body.

13. The method according to any of claims 10 to 12,
wherein, in step (c), the seal material has a uniform thickness throughout an overall area of the bottom surface of the substrate.

14. The method according to any of claims 10 to 13,
wherein, in step (c), a surface of the seal material on the bottom surface of the substrate is formed with irregularities.

15. The method according to any of claims 10 to 14,
wherein, in step (c), a through-hole is formed in the seal material on an inside of the bottom surface of the substrate, and, in step (d), the metal film is directly laminated on the substrate exposed to the through-hole.

16. The method according to claim 14 or 15,
wherein, in step (d), the metal film is formed so that the surface thereof has the irregularities on the bottom surface of the substrate.

17. The method according to any of claims 10 to 16, further comprising:
before step (a), a step (e) of forming a connecting portion electrically connected to the electronic element and a connecting portion electrically connected to the metal film, on a bottom surface of the case body; and
before step (a) or step (b), a step (f) of forming a conductive portion electrically connected to the connecting portion of a bottom surface of the case body at an outside or inside of the sidewall portion of the case body,
wherein, in step (c), the seal material on the conductive portion is removed after covering the conductive portion by the seal material, and in step (d), the metal film and the conductive portion are connected to each other.
